# EUROPÄISCHE PATENTANMELDUNG

(11) **EP 1 031 841 A2**
(43) Veröffentlichungstag der Anmeldung: **30.08.2000**
(21) Anmeldenummer: 00103734.0
(22) Anmeldetag: 22.02.2000
(51) Int. Cl.: G01R 31/28, G01R 1/073

(54) **Testadapter zur Kontaktierung von bestückten Leiterplatinen**

(30) Priorität: 23.02.1999 DE 19907727
(71) Anmelder: TEST PLUS ELECTRONIC GMBH, D-80337 München (DE)
(72) Erfinder: Ott, Rainer, 80997 München (DE)
(74) Vertreter: Körber, Wolfhart, Dr.

(57) **Zusammenfassung**

Testadapter zur Kontaktierung von bestückten Leiterplatinen 3 mit einer Nadelträgerplatte 1 zur Haltung der eng nebeneinander angeordneten Testnadeln 5, 19, mit einer ersten An von Testnadeln 5, die über in die Nadelträgerplatte 1 eingesetzte Hülsen 4 gehalten sind, in welche von unten Kontaktelemente 6, 7 zu den Testnadeln 5 hin eingesteckt sind, und mit einer zweiten Art von Testnadeln 19 mit insbesondere kleinen Durchmessern, die ohne Hülsen 4 in der Nadelträgerplatte 1 angeordnet sind und die zumindest an ihrem unteren Ende als Hohlnadeln zur Aufnahme von einsteckbaren Kontaktelementen 20, 25 ausgebildet sind, wobei die einsteckbaren Kontaktelementen 20, 25 in zusätzlichen Kontakt-Halteplatten 21, 22 befestigt sind.

## Beschreibung

Die vorliegende Erfindung betrifft Testadapter für bestückte, elektronische Leiterplatinen mit einer auf einer Trageplatte montierten zu prüfenden bestückten Leiterplatte sowie einer Nadelträgerplatte, welche Testuadeln trägt.

Testadapter für mit elektronischen Bauelementen bestückte, elektronische Leiterplatinen werden überwiegend in Verbindung mit automatischen Testsystemen eingesetzt und ermöglichen eine individuelle, schnell wechselbare elektrische Verbindung zwischen der zu testenden Leiterplatine und der Anschlußschnittstelle der Testsysteme. Je nach Größe der zu testenden Leiterplatinen und Testverfahren werden mit einem Testadapter zwischen 200 bis ca. 5000 Kontaktpunkte gleichzeitig kontaktiert.

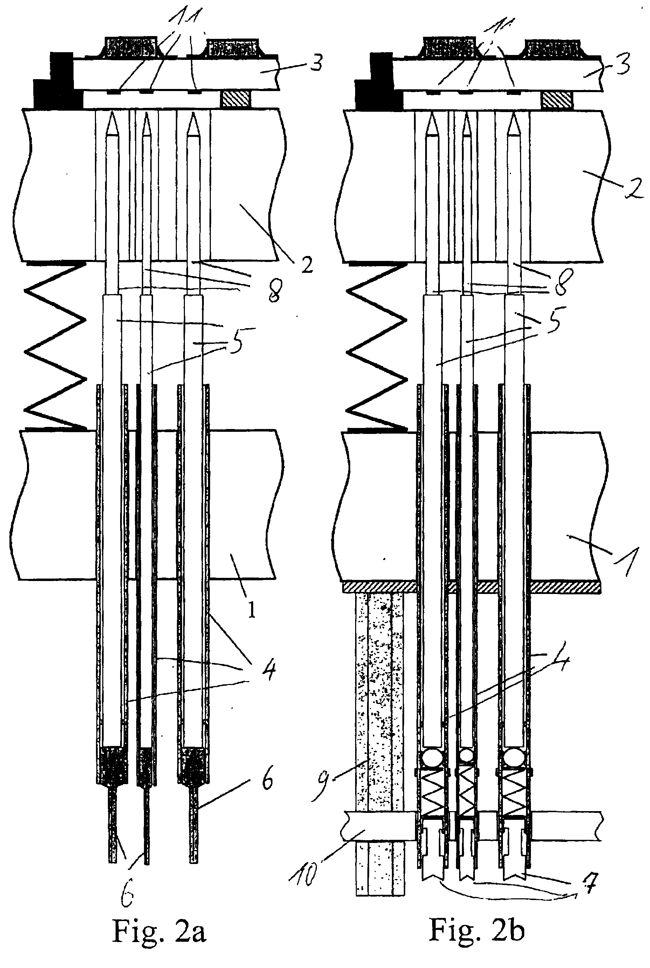

Der prinzipielle Aufbau eines konventionellen Testadapters ist in Figur 2a dargestellt. In einer Nadelträgerplatte 1 sitzen festmontierte Hülsen 4, in die Testnadeln 5 eingesetzt sind. Die Testnadeln 5 werden meist durch klemmende Befestigung (z. B. an Querschnittsverengungen der Hülsen 4) in den Hülsen 4 gehalten und weisen vorzugsweise einen inneren, gefedert beweglichen Kolben 8 auf, der die Prüfspitze der Testnadel 5 bildet. Entsprechend der Dichte der Kontaktpunkte 11 auf der zu testenden Leiterplatine 3 und dem daraus resultierenden Abstand der Kontaktpunkte 11 zueinander haben Testnadeln 5 und Hülsen 4 unterschiedlich große Durchmesser. Üblich sind heute Ausführungen, die für einen Abstand von jeweils bis zu 100 mil (2,54 mm), 75 mil (1,79 mm) bzw. 50 mil (1,27 mm) ausgelegt sind.
Zur Kontaktierung wird der vorzugsweise auf einer Tragplatte 2 befestigte Prüfling 3 entweder mit Unterdruck oder durch mechanische Niederhalter so gegen die die Prüfspitzen der Testnadeln 5 bildenden bewegbaren Kolben 8 gepreßt, daß die Testnadeln 5 und die Kontaktpunkte 11 kontaktieren.
Die Unterseite der Hülsen 4 ist meistens mit einem Kontaktelement 6, welches einen Wire-Wrap Pfosten aufweist, versehen. Über den Wire-Wrap Pfosten sind die Hülsen 4 dann mit einem Interface verdrahtet.
Bei alternativen Ausführungsformen, sogenannten verdrahtungslosen Adaptern (Figur 2b), haben die Hülsen 4 an der Unterseite ein Feder-Kontaktelement 7 und kontaktieren entweder (in der Zeichnung nicht dargestellt) eine individuell hergestellte Verbindungsplatine oder über eine sogenannte Schrägnadelkassette eine universelle Rasterplatine.
Die Testnadeln 5 müssen bei Defekt oder verschleißbedingt leicht und sehr schnell austauschbar sein, da ein defekter Testadapter bei einer automatisierten Fertigungslinie sofort einen Fertigungsstillstand und somit hohe Kosten bewirkt.

Die Kosten für die Testnadeln 5 steigen überproportional zu einem geringer werdenden Durchmesser der Testnadeln 5. Stabilität und Lebensdauer nehmen bei kleiner werdenden Testnadeln 5 deutlich ab. Bei einer für das Rastermaß 50 mil geeigneten Nadel 5 erreichen der innere bewegte Kolben 8 und die Feder bereits Durchmesser von nur noch ca. 0,45 mm.

Die fortschreitende Miniaturisierung und damit steigende Dichte der Kontaktpunkte 11 auf dem Prüfling 3 bedingt daher die Suche nach alternativen Lösungen, um bei geringem Abstand der Testnadeln 5 zueinander eine möglichst hohe Stabilität und günstige Kosten der Testnadeln 5 zu erreichen.

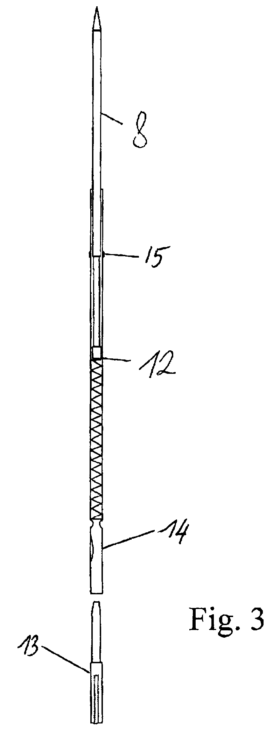

Seit vielen Jahren sind Testnadeln 12 auf dem Markt und bekannt, bei denen, wie in Figur 3 gezeigt, zur Reduzierung des Gesamtdurchmessers Anschlußstifte 13 von unten klemmend in einer Nadelhülse 14 befestigt werden.
Da hier der äußere Durchmesser einer fest montierten Hülse 4 den benötigten Gesamtdurchmesser nicht mehr zusätzlich vergrößert (bei der in Figur 3 abgebildeten Testnadel 12 ist eine fest montierte Hülse 4 für die Testnadel 12 zum Zwecke der Kontaktierung nicht nötig), lassen sich so Testnadeln 12, die bei Montage in festmontierten Hülsen 4 nur für ein minimales Raster von 75 mil (1,79 mm) eingesetzt werden können, bei Montage ohne festmontierte Hülsen bis zu einem Abstand von 50 mil (1,27 mm) verwenden, und bisherige 50 mil Testnadeln 12 bis zu einem Abstand von 40 mil (1 mm).

Nachteilig an dieser Technik ist jedoch, daß das Auswechseln von Testnadeln 12 erheblich erschwert wird. Während bei der herkömmlichen Befestigungstechnik, bei der die Testnadeln 5 durch Reibschluß in festmontierten Hülsen 4 gehalten werden und mit diesen kontaktieren, die Testnadeln 5 ohne Öffnen eines inneren Adapterteils (z. B. es Verdrahtungsbereichs der Kontaktelemente 6, 7) einfach von oben aus den festmontierten Hülsen 4 nach oben herausgezogen und auch wieder von oben in die festmontierten Hülsen 4 eingesetzt werden können, ist bei den in Figur 3 beschriebenen Testnadeln 12 zum Entfernen oder Wechseln der Testnadeln 12 ein Öffnen des für den Nichtfachmann nicht zugänglich gemachten Verdrahtungsbereiches der Testnadeln 12 erforderlich, um zunächst den Anschlußstift 13 aus der Nadelhülse 14 zu ziehen. Danach kann die Testnadeln 12 von oben aus der Nadelträgerplatte 1 herausgezogen und ersetzt werden. Nach Einsetzen einer neuen Testnadel 12 in die Nadelträgerplatte 1 von oben ist der Verdrahtungsbereich wiederum zu öffnen, um den Anschlußstift 13 wieder in die Nadelhülse 14 zu stecken.
Auch der bei einer hohen Stückzahl von zu testenden Platinen 3 in regelmäßigen Zeitabständen erforderliche Wechsel aller Testnadeln 12 gestaltet sich erheblich komplizierter, da jeder Wechsel einzeln und mit Zugriff sowohl auf den Verdrahtungsbereich als auch auf die Oberseite der Nadelträgerplatte 1 des Testadapters erfolgen muß.

Eine weitere Nachteil ist die nur unvollkommene Durchmesserreduzierung, da zur Verhinderung eines Durchrutschens der Testnadel 12 nach unten (d. h. zum Verdrahtungsbereich hin) durch die Nadelträgerplatte 1 hindurch oberhalb der Nadelträgerplatte 1 an der Testnadel 12 ein zusätzlicher Haltering 15 erforderlich ist.

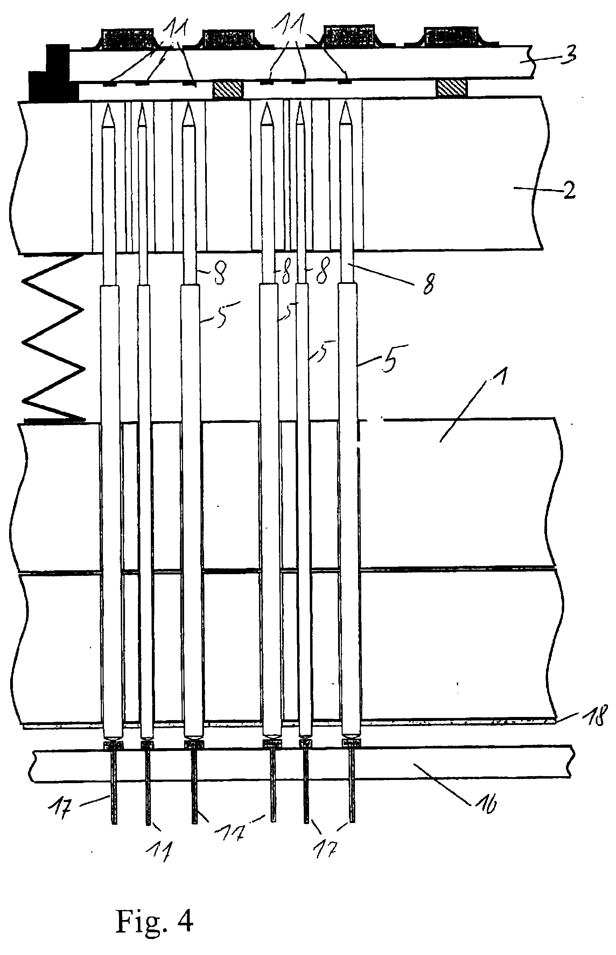

Eine alternative bekannte Lösung, die die oben genannten Nachteile vermeidet, ist in Figur 4 abgebildet. Auch hier werden Testnadeln 5 verwendet, die nicht in festmontierten Hülsen 4, sondern direkt in Bohrungen gelagert sind, die in eine vorzugsweise besonders dicke Nadelträgerplatte 1 eingebracht sind. Die in den Bohrungen in axiale Richtung frei beweglichen Testnadeln 5 liegen mit ihrem unteren (der Prüfspitze abgewandten) Ende auf Kontaktteilen 17 auf, die auf einer Tragplatte 16 montiert sind, und somit werden die Testnadeln 5 beim Testen durch die Andruckskraft des Prüflings 3 auf die Testnadeln 5 gegen die Kontaktteile 17 gedrückt.
Nachteilig an dieser Lösung ist erstens die zum Zwecke der Zugänglichkeit des Adapters erforderliche zusätzliche Kontaktstelle zwischen den Testnadeln 5 und den Kontaktteilen 17, da die Testnadeln 5 jetzt nicht mehr fest in Reibschluß mit den die Hülsen 4 ersetzenden Kontaktteilen 17 verbunden sind. Dieser Übergangskontakt wird bei jedem Wechsel des Prüflings 3, d.h. bis zu mehrere hunderttausend Mal während der Lebensdauer eines Adapters, belastet und entlastet und birgt damit das Risiko zusätzlicher Kontaktfehler bzw. erhöhter Kontaktübergangswiderstände.

Ein weiterer Nachteil entsteht dadurch, daß zur Erzielung der erforderlichen Kontaktfederkraft auf jeden Fall eine Spielpassung der Testnadeln 5 in den Bohrungen in der Nadelträgerplatte 1 gewährleistet sein muß, damit der Kontaktdruck auf den Kolben 8 der Testnadel 5 an die Kontaktstelle am Kontaktteil 17 weitergegeben werden kann. Aufgrund der beim Herstellprozeß der Testnadeln 5 und beim Erstellen der Bohrungen in der Nadelträgerplatte 1 kaum vermeidbaren Fertigungstoleranzen bedingt die erforderliche Spielpassung ein deutlich größeres Taumelspiel der Nadeln 5.

Als dritter Nachteil ergibt sich, daß sowohl bei der Erstanfertigung des Prüfadapters als auch bei späteren Änderungen aufwendige Vorkehrungen zu treffen sind (z.B. Aufbringen einer elastischen Halteschicht 18 aus einem elastischen Material auf die Nadelträgerplatte 1), damit die Testnadeln 5 nach einem Test beim Abnehmen der Leiterplatine 3 nicht mit herausgezogen werden. Diese Gefahr ist gegeben, da für den Test der in der Regel mit Lötwelle gelöteten und deshalb durch Flußmittelreste verschmutzten Leiterplatinen 3 sehr spitze Testnadeln 5 erforderlich sind, die sich oft im weicheren Lötzinn festhaken.

Da weiterhin das oben beschriebene Konzept aus mehreren Gründen nicht mit der bekannten Hülsentechnik kombinierbar ist (z. B. würden sich die Kontaktelemente 6, 7 von in die Nadelträgerplatte 1 eingebrachten Hülsen und die Trageplatte 16 für die Kontaktteile 17 gegenseitig im Wege stehen), müssen alle Kontaktverbindungen des Prüfadapters in der im Zusammenhang mit der Figur 4 beschriebenen Art und Weise ausgeführt werden. Die oben genannten Nachteile wirken sich damit nicht nur auf die typischer Weise 5% bis 10% der Nadelpositionen mit einer geforderten besonders hohen Auflösung (großen Dichte der Testnadeln 5), sondern auf 100% der verwendeten Testnadeln 5 aus.

Es ist Aufgabe der vorliegenden Erfindung, einen Testadapter zur Kontaktierung von bestückten Leiterplatten vorzuschlagen, bei dem die Testnadeln auch ohne besonderes Fachwissen leicht und schnell auswechselbar sind, und bei dem unter Verwendung von Testnadeln mit möglichst großem Durchmesser (und somit möglichst stabilen und billigen Testnadeln) eine maximale Auflösung, d. h. ein minimaler Abstand der Testnadeln und somit der möglichen Prüfpunkte zueinander, erzielt werden kann. Weiterhin ist es Aufgabe der Erfindung, einen Testadapter vorzuschlagen, bei dem ein Taumelspiel der Testnadeln reduziert und zusätzliche Kontaktfehler bzw. erhöhte Kontaktübergangswiderstände vermieden werden, und bei dem die Testnadeln weiterhin ohne zusätzliche Maßnahmen gegen ein versehentliches Herausrutschen gesichert sind.

Die Aufgabe wird gemäß ihrem Hauptanspruch gelöst. Die Erfindung wird in ihren Unteransprüchen weitergebildet.

Zur Beseitigung der bestehenden Nachteile schlägt die vorliegende Erfindung ein Testadapterkonzept vor, bei dem in den Regionen des gesamten Testnadelbereiches, in denen nur eine durchschnittliche Auflösung an Prüfstellen benötigt wird und in denen somit ein mittlerer Testnadelabstand ausreicht, die vorteilhafte und bewährte Klemmtechnik zwischen Testnadeln 5 erster Art und Hülsen 4 verwendet wird. In den Regionen des gesamten Testuadelbereiches, in denen eine höhere Auflösung der Prüfstellen und somit ein reduzierter Testnadelabstand benötigt wird, werden gemäß der vorliegenden Erfindung zusätzlich oder alternativ zu den in Hülsen 4 gesteckten Testnadeln 5 erster Art weitere Testnadeln 19 zweiter Art verwendet, wobei die Testnadeln 19 zweiter Art ohne Hülsen 4 in Bohrungen in der Nadelträgerplatte 1 angeordnet sind, und somit der durch das Weglassen der Hülsen eingesparte Durchmesser ganz oder teilweise den Testnadeln zugute kommen kann. Die Testnadeln 19 zweiter Art sind dabei zumindest an ihrem unteren, der zu prüfenden Leiterplatte 3 abgewandten Ende als Hohlnadel zur Aufnahme eines einsteckbaren Kontaktelements 20, 25 ausgebildet. Die einsteckbaren Kontaktelemente 20, 25 sind in zusätzlichen, von der Nadelträgerplatte 1 beabstandeten Kontakt-Halteplatten 21, 22 befestigt und mit einem Terminal elektrisch verbindbar. Vorzugsweise werden die Kontakt-Halteplatten 21, 22 an der oder den Hülsen 4 einer oder mehrerer benachbarter Testnadeln 5 erster Art befestigt oder über einen Abstandshalter 26 direkt mit der Nadelträgerplatte 1 verbunden.
Vorteilhaft ist dabei neben der Verwendung der vorteilhaften und bewährten Klemmtechnik zwischen Testnadel 5 und Hülse 4, daß die Möglichkeit des einfachen Testnadelwechsels durch Ziehen bzw. Stecken der Testnadeln 5, 19 von der der zu prüfenden Leiterplatte zugewandten Seite der Nadelträgerplatte 1 aus beibehalten wird. Ein weiterer wichtiger Vorteil der erfindungsgemäßen Lösung ist die Kombinationsmöglichkeit mit der bestehenden Hülsenmontage, so daß weiterhin auf die bestehende und kostengünstige Fertigungstechnik für Positionen mit 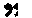 normaler" Anforderung an die Dichte der Testnadeln 5, 19 zurückgegriffen werden kann.

Ein Ausführungsbeispiel der Erfindung wird nachfolgend unter Bezugnahme auf die Zeichnung näher beschrieben. In der Zeichnung zeigen
- Fig. 1: einen Querschnitt durch einen erfindungsgemäßen Testadapter, der mit Feder-Kontaktelementen 7, 20 ausgestattet ist;
- Figs. 2a, 2b: einen Querschnitt durch einen Testadapter nach dem Stand der Technik;
- Fig. 3: eine Testnadel, die dem Stand der Technik entspricht;
- Fig. 4: einen Querschnitt durch einen weiteren Testadapter nach dem Stand der Technik;
- Fig. 5: eine Aufsicht auf die Nadelträgerplatte 1 eines erfindungsgemäßen Testadapters von der der zu prüfenden Leiterplatte abgewandten Seite;
- Fig. 6: einen Querschnitt durch einen erfindungsgemäßen Testadapter, der mit Kontaktelementen 6, 25 ausgestattet ist, die Wire-Wrap Pfosten aufweisen;

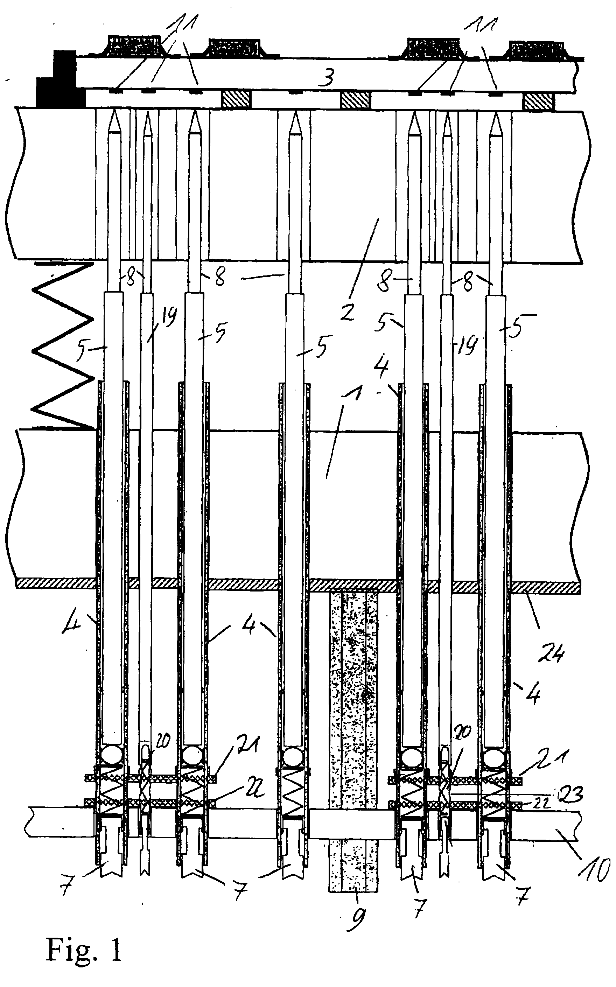

Figur 1 stellt die erfindungsgemäße Lösung am Beispiel eines Ausführungbeispieles dar, bei dem festmontierte Hülsen 4 mit Feder-Kontaktelementen 7 verwendet werden. Die Hülsen 4 werden von der Nadelträgerplatte 1 in Bohrungen getragen und sind an ihrem unteren Ende mit Feder-Kontaktelementen 7 versehen. Die unteren Enden der Hülsen 4 werden zur besseren Positionierung der Feder-Kontaktelemente 7 von einer mit der Nadelträgerplatte 1 über Abstandshalter 9 verbundenen Stützplatte 10 geführt. In die Hülsen 4 sind von oben Testnadeln 5 erster Art steckbar, so daß diese durch Reibschluß in den Hülsen 4 gehalten werden. Weiter weist der erfindungsgemäße Testadapter eine zweite Art von Testnadeln 19 auf, die ohne Hülsen 4 in Bohrungen in der Nadelträgerplatte 1 angeordnet sind und zumindest an ihrem unteren Ende als Hohlnadeln zur Aufnahme von einsteckbaren Feder-Kontaktelementen 20 ausgebildet sind, wobei die einsteckbaren Feder-Kontaktelemente 20 in zusätzlichen Kontakt-Halteplatten 21, 22 befestigt sind.
Vorzugsweise werden über den gesamten Nadelbereich verteilt eine oder mehrere voneinander unabhängige Kontakthalteplatten 21, 22 vorgesehen, die lediglich den Bereich extrem kleiner Nadeln, d.h. den Bereich mit einer besonders hohen Dichte an Prüfpunkten 11 und somit auch Testnadeln 5, 19 abdecken. Die in den Kontakt-Halteplatten 21, 22 befestigten Kontaktelemente 20, 25 sind so ausgebildet, daß sie für eine Klemmbefestigung der Testnadeln 19 in Form eines Reibschlusses geeignet sind. Je nach Ausführung sind die Kontaktelemente 20 mit den Kontakt-Halteplatten 21, 22 lösbar oder unlösbar verbunden.

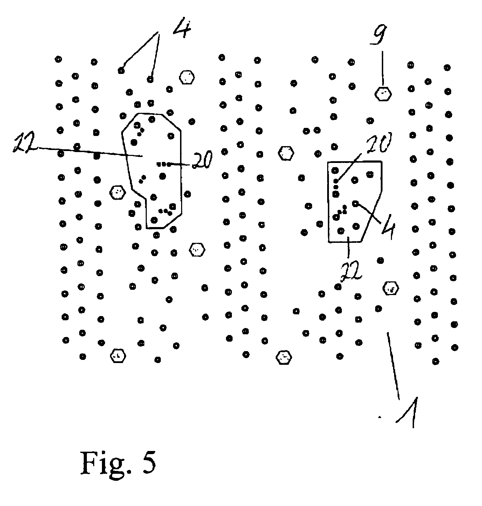

Ein Beispiel für die Anordnung dieser Kontakt-Halteplatten 21, 22 über den ganzen Testnadelbereich zeigt Figur 5, in der die Nadelträgerplatte 1 (ohne Stützplatte 10 für die Hülsen 4) von unten dargestellt ist.
Wie gut erkennbar ist, erstrecken sich die Kontakt-Halteplatten 21, 22 nur über Bereiche mit extrem hoher Dichte an Testnadeln 5, 19 und somit über Bereiche mit besonders kleinen Testnadeln 19. Neben den Hülsen 4 für die Testnadeln 5 erster Art sind in Fig. 5 Kontaktelemente 20, 25 für die Testnadeln 19 zweiter Art, untere Kontakt-Halteplatten 22, welche die Kontaktelemente 20, 25 tragen, sowie Abstandhalter 9 für die nicht dargestellte Stützplatte 10 abgebildet.

Eine besonders einfache Ausführung für die Montage der Kontakt-Halteplatten 21, 22 ergibt sich, wenn sowohl für die Festlegung der Position als auch für die Festlegung der Einbauhöhe der Kontakt-Halteplatten 21, 22 die Fixierung über bestehende in der Nadelträgerplatte 1 festmontierte Hülsen 4 und gegebenenfalls eine über Abstandshalter 9 mit der Nadelträgerplatte 1 verbundene Stützplatte 10 erfolgt. Die Festlegung der Bohr- und Fräsdaten erfolgt sinnvollerweise über ein entsprechendes Softwareprogramm.

Zur Erzielung einer guten Federwirkung und somit Kontaktes des mit der zweiten Art von Testnadeln 19 in Reibschluß befindlichen Kontaktelements 20, 25 ist es von Vorteil, das Kontaktelement 20, 25 im Kontaktbereich, also in dem Bereich in dem sich das Kontaktelement 20, 25 in die Hohlnadel der Testnadel 19 erstreckt, als Hohlkörper auszuführen, da so eine bessere Klemmkraft zwischen der Testnadel 19 zweiter Art und dem Kontaktelement 20, 25 ohne Gefahr einer verbleibenden Deformation aufgebaut werden kann.

Eine hohe Änderungsfreundlichkeit und Flexibilität ergibt sich, wenn die Kontaktelement 20, 25 zwischen zwei Kontakt-Halteplatten 21 und 22 fixiert werden. Bei sehr kleinen Kontaktelementen 20, 25, bei denen eine Ausführung als Feder-Kontaktelement 20 nicht mehr zweckmäßig ist, bilden die beiden parallel übereinander angeordneten, voneinander beabstandeten Kontakt-Halteplatten 21, 22 einen separaten, geschützten Verdrahtungsraum. Der Mittelbereich 23 des Kontaktelements 20, 25 ist dann vorzugsweise verjüngt, damit dort z. B. ein dünner isolierter Draht (z. B. Kupferlackdraht) angelötet werden kann, um z. B. zu weiteren Kontaktelementen 20 verdrahtete Verbindungen herzustellen.

Sollten später einmal Nadelpositionen nachgesetzt werden müssen, können die Kontakt-Halteplatten 21, 22 mit vertretbarem Aufwand demontiert und wahlweise nachgebohrt oder durch neugebohrte Kontakt-Halteplatten 21, 22 ersetzt werden.

Da die Testnadeln 19 an ihrem unteren Ende von den Kontaktelementen 20, 25 gehalten und gestützt werden, sind an den Testnadeln 19 keine zusätzlichen Halteringe 15 erforderlich. Bei entsprechend präziser Bohrung ist somit eine Testnadel 19, die bei einem konventionellen Testadapter mit Hülsen 4 bis zu einem Abstand von 75 mil verwendet werden kann, bis 45 mil, und eine Testnadel 19, die bei einem konventionellen Testadapter mit Hülsen 4 bis zu einem Abstand von 50 mil verwendet werden kann, bis 35 mil Abstand verwendbar.

Bei vakuumbetriebenen Adaptoren ist ein zusätzliche Abdichtung der Testnadeln 19 vorgesehen. Hierzu wird vorzugsweise unterhalb der Nadelträgerplatte 1 eine elastische Dichtungsschicht 24 aufgebracht und die Bohrungen in der Nadelträgerplatte 1 so ausgeführt, daß die Wandung der elastischen Dichtungsschicht 24 die Testnadeln 19 dicht umschließt.

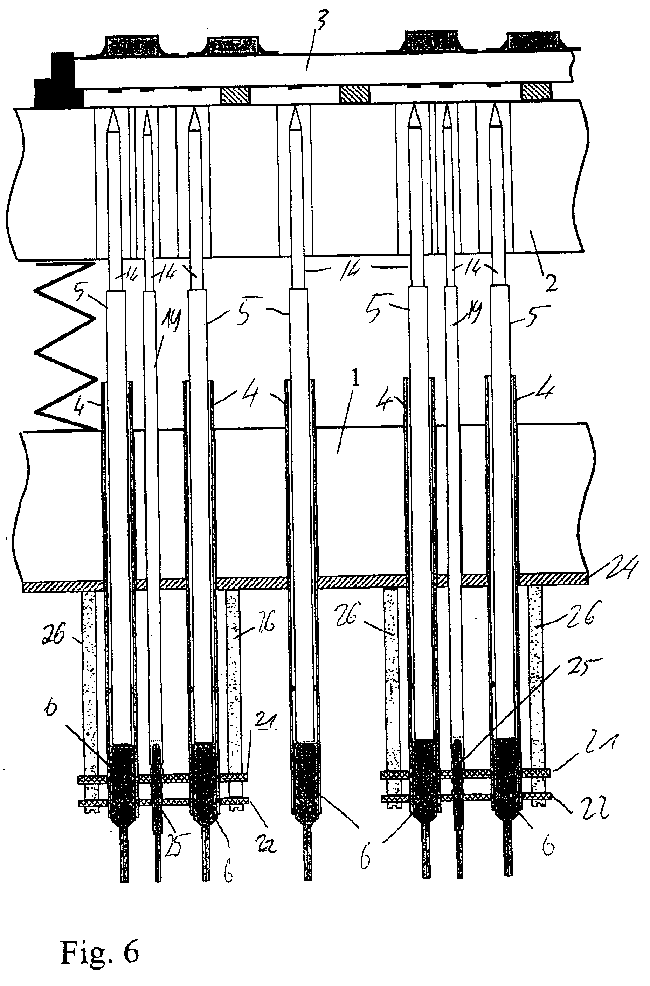

Figur 6 zeigt eine alternative Ausführung für eine Verdrahtung in Wire-Wrap Technik. Die Kontakt-Halteplatten 21, 22 werden vor der Verdrahtung über die bereits in der Nadelträgerplatte 1 befestigten Hülsen geschoben. Auch hier wurde wieder eine Darstellung mit zwei Kontakt-Halteplatten 20 und 21 gewählt. Da die Kontakt-Halteplatten 21, 22 hier nicht auf einer bestehenden Stützplatte 10 für die Hülsen 4 abgestützt werden können, werden sie vorzugsweise über verschraubte Abstandshalter 26 an der Nadelträgerplatte 1 befestigt. Der obere Teil des hier abgebildeten Kontaktelements 25 entspricht dem oben beschriebenen Feder-Kontaktelement 20, nach unten ist jedoch an Stelle eines gefederten Kontaktes ein Wire-Wrap Pfosten vorgesehen.
Auch hier bietet wieder die Verwendung mehrerer, räumlich voneinander getrennter Kontakt-Halteplatten 21, 22 den Vorteil, daß der freie Bereich in Hinblick auf mögliche Änderungen flexibel, und Raum für eventuell erforderliche Sondereinbauten und für die Verdrahtung wie bei konventionellen Adaptern erhalten bleibt.

## Patentansprüche

1. Testadapter zur Kontaktierung von bestückten Leiterplatinen (3) mit einer Nadelträgerplatte (1) zum Halten von eng nebeneinander angeordneten Testnadeln (5, 19),
mit einer ersten Art von Testnadeln (5), die über in die Nadelträgerplatte (1) eingesetzte Hülsen (4) gehalten sind, in welche von unten Kontaktelemente (6, 7) zu den Testnadeln (5) hin eingesteckt sind,
und mit einer zweiten Art von Testnadeln (19) mit insbesondere kleinen Durchmessern, die ohne Hülsen (4) in der Nadelträgerplatte (1) angeordnet sind und die zumindest an ihrem unteren Ende als Hohlnadeln zur Aufnahme von einsteckbaren Kontaktelementen (20, 25) ausgebildet sind,
wobei die einsteckbaren Kontaktelemente (20, 25) in zusätzlichen Kontakt-Halteplatten (21, 22) befestigt sind.

2. Testadapter gemäß Anspruch 1,
dadurch gekennzeichnet, daß eine Vielzahl von unabhängigen Kontakt-Halteplatten (21, 22) vorgesehen ist, wobei die Kontakt-Halteplatten (21, 22) jeweils einen Bereich beieinander liegender Testnadeln (5, 19) zweiter Art umfassen.

3. Testadapter gemäß Anspruch 2,
dadurch gekennzeichnet, daß die Kontakt-Halteplatten (21, 22) für die Kontaktelemente (20, 25) der Testnadeln (19) zweiter Art an ein oder mehreren Hülsen (4) benachbarter Testnadeln (5) erster Art zur Führung und/oder Halterung befestigt sind.

4. Testadapter gemäß Anspruch 2,
dadurch gekennzeichnet, daß die Kontakt-Halteplatten (21, 22) von an der Nadelträgerplatte (1) befestigten Abstandshaltern (26) getragen werden.

5. Testadapter gemäß einem der Ansprüche 1 bis 4,
dadurch gekennzeichnet, daß auf der Nadelträgerplatte (1) eine aus einem elastischen Material bestehende Dichtungsschicht (24) aufgebracht ist.

6. Testadapter gemäß einem der Ansprüche 1 bis 5,
dadurch gekennzeichnet, daß die an den Kontakt-Halteplatten (21, 22) befestigten Kontaktelemente (20, 25) für die Testnadel (19) zweiter An als ein in die am unteren Ende der Testnadeln (19) zweiter Art ausgebildete Hohlnadeln steckbares elastisch verformbares Kontaktteil mit einem zumindest im Steckbereich innen hohlen Abschnitt ausgeführt sind.

7. Testadapter gemäß einem der Ansprüche 1 bis 6,
dadurch gekennzeichnet, daß das Kontaktelement (25) an seinem von der Testnadel (19) zweiter Art abgewandten Ende als Wire-Wrap Kontaktpfosten ausgeführt ist.

8. Testadapter gemäß einem der Ansprüche 1 bis 6,
dadurch gekennzeichnet, daß das Kontaktelement an seinem von der Testnadel (19) zweiter Art abgewandten Ende als Feder-Kontaktelement (20) ausgeführt ist.

9. Testadapter gemäß Anspruch 8,
dadurch gekennzeichnet, daß das Kontaktelement (20, 25) auswechselbar zwischen zwei voneinander beabstandeten, parallel übereinander angeordneten Kontakt-Halteplatten (21, 22) fixiert ist.

10. Testadapter gemäß Anspruch 8 oder 9,
dadurch gekennzeichnet, daß ein Mittelteil (23) des Kontaktelements (20, 25) für eine zusätzliche Anschlußdrahtbefestigung ausgebildet ist.

11. Testadapter gemäß einem der Ansprüche 1 bis 10,
dadurch gekennzeichnet, daß am Kontaktelement (20, 25) vorkonfektionierte Verbindungskabel angebracht sind.
